(19) Europäisches Patentamt
European Patent Office
Office européen des brevets

(11) EP 3 144 997 A1

(12) **EUROPEAN PATENT APPLICATION**
published in accordance with Art. 153(4) EPC

(43) Date of publication:
**22.03.2017 Bulletin 2017/12**

(21) Application number: **15800168.5**

(22) Date of filing: **24.03.2015**

(51) Int Cl.:
***H01L 51/54*** *(2006.01)*

(86) International application number:
**PCT/CN2015/074966**

(87) International publication number:
**WO 2015/180524 (03.12.2015 Gazette 2015/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **30.05.2014 CN 201410239365**

(71) Applicant: **Guangzhou Chinaray Optoelectronic Materials Ltd.**
**Guangzhou, Guangdong 510663 (CN)**

(72) Inventor: **YAN, Xiaolin**
**Guangzhou**
**Guangdong 510663 (CN)**

(74) Representative: **Manitz, Finsterwald & Partner GbR**
**Martin-Greif-Strasse 1**
**80336 München (DE)**

# (54) ORGANIC MIXTURE, COMPOSITION CONTAINING SAME, ORGANIC ELECTRONIC DEVICE AND APPLICATION

(57) Provided are an organic mixture and a composition containing same. The organic mixture comprises a first host material H1, a second host material H2 for forming an exciplex with the first main material H1, and an organic fluorescent light-emitting material E1, wherein the H1 and the H2 have a heterogeneous structure of II type, and the light-emitting wavelength of E1 is greater than or equal to that of the exciplex formed by H1 and H2. The present invention can be used for manufacturing a light-emitting device having the advantages of low costs, high efficiency, long service life and low roll-off.

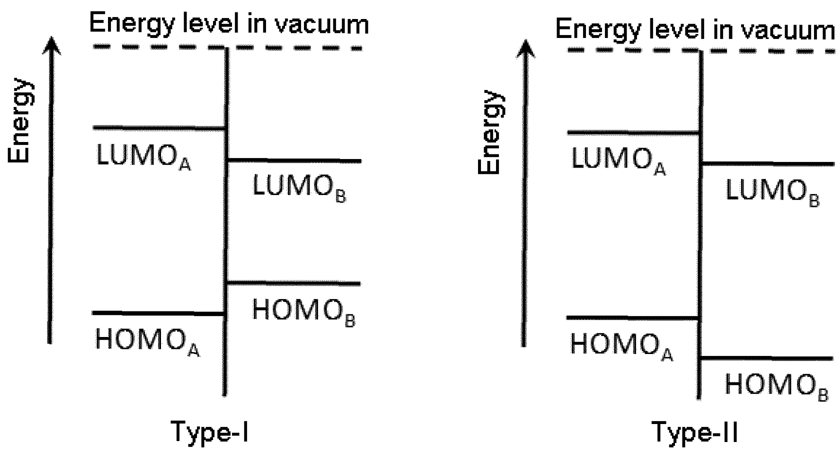


Fig. 1

EP 3 144 997 A1

## Description

### FIELD OF THE INVENTION

The present invention relates to the field of electroluminescent materials, and, more particularly, to an organic mixture, a formulation and an organic electronic device comprising the organic mixture, and the applications of the organic mixture in the organic electronic devices, especially in organic electroluminescent devices.

### BACKGROUND

Due to a diversity in a synthesis, a relatively low manufacturing cost, and an excellent optoelectronic property of an organic semiconductor material, an organic light-emitting diode (OLED) has a great potential in the applications, such as a flat panel display and general lighting.

In order to improve a luminous efficiency of the OLED, a plurality of fluorescence or phosphorescent-based emissive material systems have been developed. An OLED using fluorescence materials has a superior reliability, however, internal quantum efficiency under an electrical excitation, has been limited to 25% due to a ratio of an exciton between singlet and triplet being 1:3. As a contrast, an OLED using phosphorescent material has achieved an internal quantum efficiency of almost 100%. But the phosphorescent OLED has a significant problem of roll-off effect, that is, the luminous efficiency decreases rapidly with the increasing of an electric current or voltage, which is particularly disadvantageous to high brightness applications. In order to solve the problem of high roll-off effect of the phosphorescent OLED, Kim et al., has achieved OLEDs with a low roll-off and a high efficiency, through using a co-host being able to form an exciplex, together with a metal complex used as a phosphorescent emitter. (As disclosed in Adv. Func. Mater. 2013 DOI- 10.1002/adfm.201300547, by Kim et al, and Adv. Func. Mater. 2013, DOI- 10.1002/adfm.201300187 , by Kim et al.)

Additionally, the most of commercially usable phosphorescent materials are hitherto metal complexes based on iridium and platinum, which are rare and expensive. Moreover, the synthesis of the complexes is also complicated, and the cost is pretty high. In order to overcome a plurality of problems on raw materials of iridium and platinum complex being rare and expensive, and the synthesis of the complex being complicated, Adachi has proposed a concept of reverse intersystem crossing, which may use a plurality of organic compounds, instead of using a metal complex, to achieve a high efficiency comparable to the phosphorescent OLEDs. This concept has been achieved by combing a plurality of different materials, for example, 1) using an exciplex, as disclosed by Adachi, et al, Nature Photonics, Vol6, p253 (2012); 2) using a thermally activated delayed fluorescence material, TADF, as disclosed by Adachi et al., Nature Vol 492, 234, (2012).

But, the life span of such OLED devices still needs to be improved. Therefore, the current technology, particularly the material solution, still needs to be improved and developed.

### BRIEF SUMMARY OF THE DISCLOSURE

According to the above described defects, the purpose of the present invention is providing an organic mixture, a formulation and an organic electronic device containing the same, and the application thereof, in order to solve the technical problem of existing electroluminescent phosphorescent material suffering from a plurality of problems including a high cost, a significant roll-off effect, and a low life span.

In order to achieve the above mentioned goals, the technical solution of the present invention to solve the technical problems is as follows:

> An organic mixture wherein, it comprises a first host material H1, a second host material H2 applied to form an exciplex together with the first host material H1, and an organic fluorescence emissive material E1, the said H1 and H2 forms a type-II semiconductor heterojunction structure, and the emitting wavelength of E1 is larger than or equal to that of the exciplex formed by H1 and H2.

A formulation comprises the said organic mixture, and at least one organic solvent.

An application of the above said organic mixture in an organic electronic device.

An organic electronic device comprises the said organic mixture.

Benefits: The organic mixture provided in the present invention comprises a co-host capable of forming an exciplex, and an organic fluorescence emissive material, also, H1 and H2 forms a type-II semiconductor heterojunction structure, the emitting wavelength of E1 is larger than or equal to that of the exciplex formed by H1 and H2. By a combination of the three, it may improve the emitting efficiency and life span of the electroluminescent devices, and may provide a solution to manufacture a light-emitting device with low cost, high efficiency, long life span, and low roll-off effect.

BRIEF DESCRIPTION OF THE DRAWINGS

FIG. 1 illustrates a semiconductor heterojunction structure as provided in the present invention, showing two possible types of relative positions on energy levels of a highest occupied molecular orbital (HOMO) and a lowest unoccupied molecular orbital (LUMO), when two organic semiconductor materials A and B come into contact, wherein, the type-II is a preferred heterojunction structure formed between the first and the second host material in the present invention.

DETAILED DESCRIPTION OF EMBODIMENTS

The present invention provides an organic mixture and their application in organic electroluminescent device, in order to make the purpose, technical solution and the advantages of the present invention clearer and more explicit, further detailed descriptions of the present invention are stated here, referencing to the attached drawings and some embodiments of the present invention. It should be understood that the detailed embodiments of the invention described here are used to explain the present invention only, instead of limiting the present invention.

A preferred embodiment of the organic mixture provided in the present invention, includes a first host material H1, a second host material H2 and an organic fluorescence emissive material E1, wherein, H1 and H2 own a type-II heterojunction structure, and H1 and H2 together may form an exciplex, the emitting wavelength of E1 is larger than or equal to that of the exciplex formed by H1 and H2.

Wherein, a heterojunction is an interface region formed by two different semiconductors contacting each other, which may be divided into type-I and type-II according to the alignment of the conduction band (LUMO) and the valence band (HOMO) of the two materials in the heterojunction. A basic characteristic of the type-II heterojunction is a spatial separation of both electrons and holes in the vicinity of the interface, and a localization in a plurality of self-consistent quantum wells. Due to overlapping of a plurality of wave functions near the interface, it leads to a reduction of a plurality of optical matrix elements, which extends a radiation lifetime and reduces an exciton binding energy.

In the present embodiment, the first host material H1 and the second host material H2 can form an exciplex co-host, combined with the organic fluorescence emissive material E1, it may improve the emitting efficiency, reduce the roll-off, and extend the life span. Also, the emitting wavelength of the organic fluorescence emissive material E1 is larger than that of the exciplex formed by H1 and H2. In addition, the absorption spectrum of E1 is at least partially overlapping with the emitting spectrum of the exciplex formed by H1 and H2. A possible advantage of this arrangement is that, the energy of the exciplex may be transferred to the emissive material E1 through a resonance energy transfer, that is the so-called Forster transfer. In the embodiments of the present invention, in the said organic mixture, counted by mass percentage, E1 is no more than 15%, preferably, no more than 10%, more preferably, no more than 8%, and the most preferably, no more than 7%.

In the embodiments of the present invention, the terms of the host material and the matrix material have the same meaning, and are all interchangeable.

In a preferred embodiment, the said organic mixture, wherein, $\min(\Delta(LUMO_{H1}\text{-}HOMO_{H2}), \Delta(LUMO_{H2}\text{-}HOMO_{H1}))$ is smaller than or equal to the lowest energy level of the triplet excited states of both H1 and H2. The energy of the exciplex formed by the first host material H1 and the second host material H2 is determined by $\min(\Delta(LUMO_{H1}\text{-}HOMO_{H2}), \Delta(LUMO_{H2}\text{-}HOMO_{H1}))$. A possible advantage of such an arrangement is that, the excited state of the system may preferentially occupy the exciplex states with the lowest energy, or it may facilitate energy transfer from the triplet excited states of H1 and H2 to the exciplex states, so as to improve the density of the exciplex states.

In the embodiments of the present invention, the energy level structure of organic materials, such as the HOMO, LUMO, triplet energy level (T1) and singlet energy level (S1) are playing a key role. The methods to determine these energy levels are presented in the following.

The energy levels of HOMO and LUMO may be measured by photoelectric effects, including an XPS (X-ray photoelectron spectroscopy) method, a UPS (Ultraviolet photoelectron spectroscopy) method, or a CV (Cyclic Voltammetry) method. Recently, a quantum chemical method, such as a density function theory (DFT), has also become an effective method to calculate a molecular orbital energy level.

The triplet energy level T1 of an organic material may be measured by low temperature time-resolved fluorescence spectrums, or may be achieved by quantum simulations (such as Time-dependent DFT), for example, by using a business software of Gaussian 03W (Gaussian Inc.). A detailed simulation method may be referred to WO2011141110.

The singlet energy level S1 of an organic material, may be determined by an absorption spectrum, or a photoluminescence spectrum, and may also be achieved by quantum simulations (such as Time-dependent DFT).

It should be noted that, an absolute value of HOMO, LUMO, T1 or S1 is each dependent of the applied measurement method or calculation method, and even for a same method, different evaluation methods may give different absolute values. For example, different HOMO/LUMO values may be given by using a starting point and a peak point in a CV curve. Therefore, a reasonable and meaningful comparison should be carried out by the same measurement

method and the same evaluation method. In the description of the embodiments in the present invention, the values of HOMO, LUMO, T1 and S1, are based on a time-dependent DFT simulation, which does not affect the applications of other measurement or calculation methods.

In some embodiments, the abs($LUMO_{E1}$-min($LUMO_{H1}$, $LUMO_{H2}$)) is no more than 0.3eV, preferably, it is no more than 0.25eV, the most preferably, it is no more than 0.2eV.

In some embodiments, the abs($HOMO_{E1}$-max($HOMO_{H1}$, $HOMO_{H2}$)) is no more than 0.3eV, preferably, it is no more than 0.25eV, the most preferably, it is no more than 0.2eV.

In a preferred embodiment, $LUMO_{E1}$ is larger than min($LUMO_{H1}$, $LUMO_{H2}$).

In another preferred embodiment, $HOMO_{E1}$ is smaller than max($HOMO_{H1}$, $HOMO_{H2}$).

Suitable H1, H2, and E1 are introduced by, but not limited to, the following descriptions:

H1 and H2 may each be selected from a plurality of small molecular materials or polymer materials independently.

The term "small molecule" defined in the present disclosure is referring to a molecule that is not a polymer, oligomer, dendrimer, or blend; more particularly, there is no repeating structure in the small molecules. A molecular weight of the said small molecule is no more than 3000 grams per mole, preferably, it is no more than 2000 grams per mole, and the most preferably, it is no more than 1500 grams per mole.

The said polymer includes a homopolymer, a copolymer, and a block copolymer. Also, in the present invention, a polymer further includes a dendrimer, whose synthesis and application may be referred to [Dendrimers and Dendrons, Wiley-VCH Verlag GmbH & Co. KGaA, 2002, Ed. George R. Newkome, Charles N. Moorefield, Fritz Vogtle].

A conjugated polymer is a polymer, whose backbone is mainly composed by a plurality of sp2 hybrid orbitals of a plurality of C atoms, a plurality of famous examples include a polyacetylene and a poly(phenylene vinylene), the C atoms in the backbone may also be substituted by other non-C atoms, and, even when the sp2 hybrid in the backbone is broken by a plurality of natural defects, it may still be considered as a conjugated polymer. Additionally, in the present invention, a conjugated polymer further includes those containing a plurality of aryl amines, aryl phosphines, heteroarmoticses, organometallic complexes and more.

In a preferred embodiment, H1 and H2 are selected from small molecular materials.

Suitable materials for H1 and H2, each may be selected independently from a hole transport material (HTM), an electron transport material (ETM), a triplet host material and a singlet host material. For example, detailed descriptions on these organic functional materials are included in three patent documents of WO2010135519A1 US20090134784A1 and WO2011110277A1 therefore, the entire contents of which are incorporated herein by reference.

In a preferred embodiment, H1 and H2 are selected from organic small molecular materials. More detailed descriptions on these functional materials are described in the following (but, not limited thereto).

1. HTM

Sometimes, an HTM is also called a p-type organic semiconductor material. A suitable organic HTM material may optionally be selected from those compounds comprising the following structure units: a phthalocyanine, a porphyrin, an amine, an aromatic amine, a triarylamine, a thiophene, a fused thiophene (such as a dithienothiophene and a dibenzothiphene), a pyrrole, an aniline, a carbazole, and indolocarbazole, and their derivatives thereof.

Embodiments on cyclic aromatic amine derivative compounds which may be applied as an HTM include (but not limited to) the following general structure:

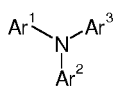
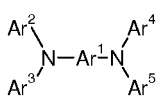
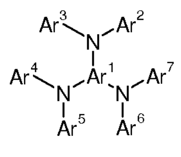
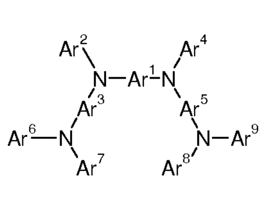
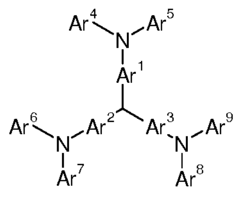

Wherein, each $Ar^1$ to $Ar^9$ may be selected independently from a plurality of cyclic aromatic hydrocarbon groups,

such as: benzene, diphenyl, triphenyl, benzo, naphthalene, anthracene, phenalene, phenanthrene, fluorene, pyrene, chrysene, perylene, azulene; from a plurality of aromatic heterocyclic groups, such as dibenzothiophene, dibenzofuran, furan, thiophene, benzofuran, benzothiophene, carbazole, pyrazole, imidazole, triazole, isoxazole, thiazole, oxadiazole, oxatriazole, dioxolane, thiadiazole, pyridine, pyridazine, pyrimidine, pyridine, triazine, oxazine, oxathiazine, oxadiazine, indole, benzimidazole, indazole, indoxazine, benzoxazole, benzisoxazole, benzothiazole, quinoline, isoquinoline, (hetero) naphthalene, quinazoline, quinoxaline, naphthalene, phthalocyanine, pteridine, xanthenes, acridine, phenazine, phenothiazine, phenoxazine, dibenzoselenophene, benzoselenophene, benzofuropyridine, indolocarbazole, pyridylindole, pyrrolodipyridine, furodipyridine, benzothienopyridine, thienodipyridine, benzoselenophenopyridine and selenophenodipyridine; or from a plurality of groups containing 2 to 10 cycle-structures, which may be the same or different types of cyclic aromatic hydrocarbon groups or aromatic heterocyclic groups, and being linked with each other directly or through at least one of the following groups: such as oxygen atom, nitrogen atom, sulfur atom, silicon atom, phosphorus atom, boron atom, chain structure unit and aliphatic ring group. Wherein, each Ar may be further substituted, and the substituent group may be selected from hydrogen, alkyl, alkoxy, amino, alkene, alkynyl, aralkyl, heteroalkyl, aryl and heteroaryl groups.

In one embodiments, $Ar^1$ to $Ar^9$ may be selected independently from groups containing the following:

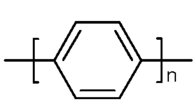
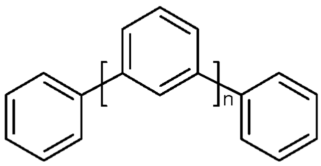
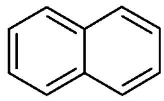
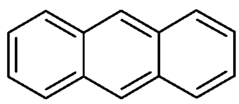

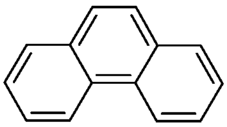
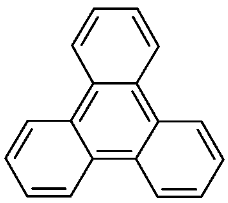
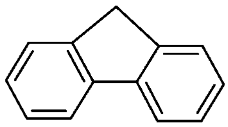

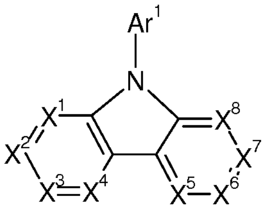
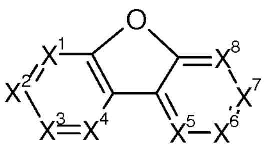
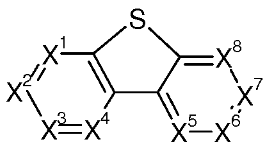

Wherein, n is an integer from 1 to 20; $X^1$ to $X^8$ is CH or N; $Ar^1$ is defined as above. More embodiments of cyclic aromatic amine-derived compounds may further be found in US3567450, US4720432, US5061569, US3615404 and US5061569.

Suitable embodiments which may act as HTM compounds are listed in the following table:

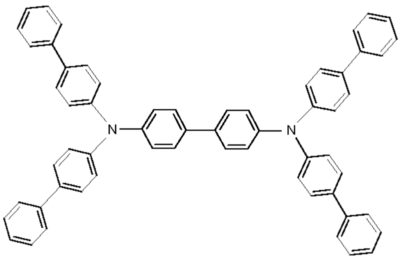
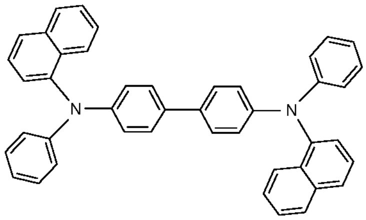

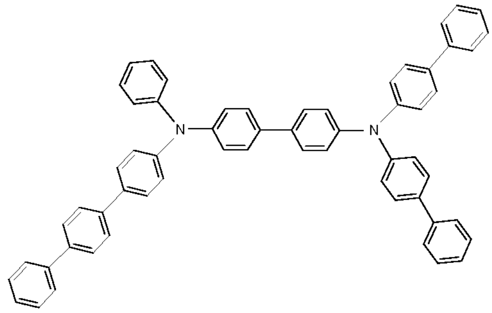

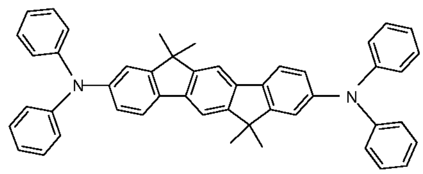

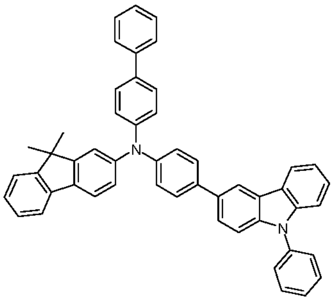

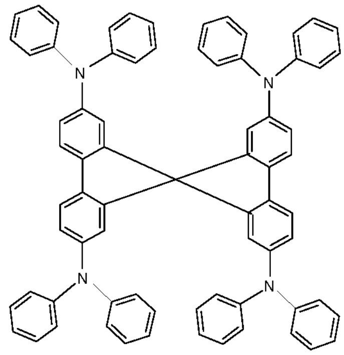

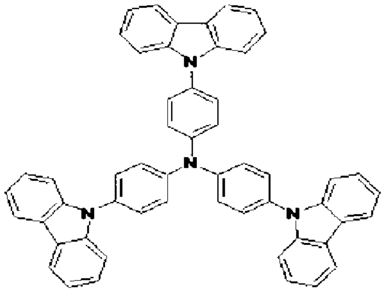

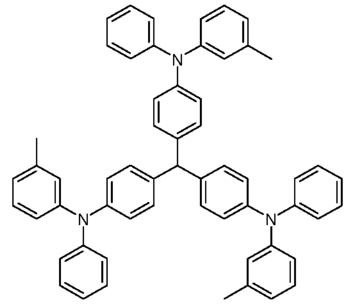

2. ETM

Sometimes, an ETM is also called an n-type organic semiconductor material. In principle, there is no special limitation on embodiments of suitable ETM materials, and any metal complex or organic compounds may be applied as an ETM, if they could transport electrons. A preferred organic ETM material may be selected from AlQ3, phenazine, phenanthroline, anthracene, phenanthrene, fluorene, bifluorene, spiro-bifluorene, phenylene-vinylene, triazine, triazole, imidazole, pyrene, perylene, trans-indenofluorene, cis-indenonfluorene, dibenzol-indenofluorene, Indenonaphthalene, benzanthracene, and the derivatives thereof.

On the other hand, compounds that may be applied as an ETM including at least one of the following groups:

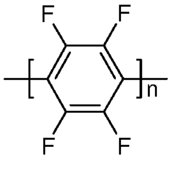 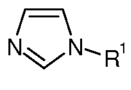 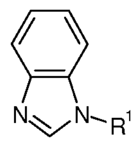 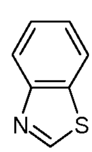 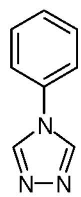 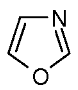 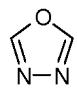

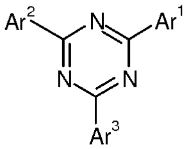 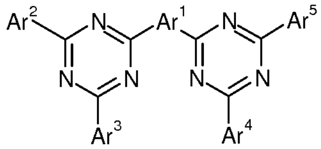 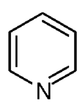 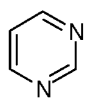 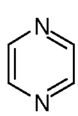 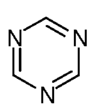

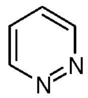
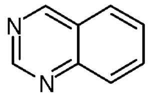
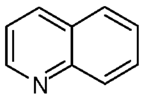
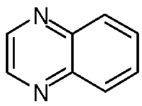
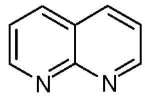
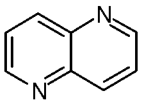
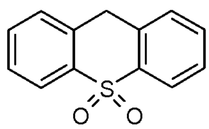

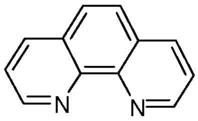
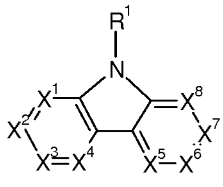
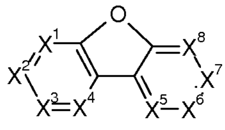
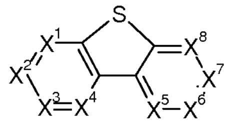

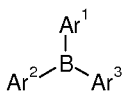
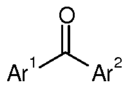
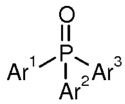
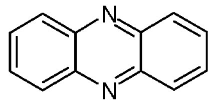

Wherein, $R^1$ may be selected from the following groups: hydrogen, alkyl, alkoxy, amino, alkene, alkyne, aralkyl, heteroalkyl, aryl and heteroaryl groups, when they are aryl or heteroaryl groups, they have the same meanings as that of the $Ar^1$ in the above said HTM, $Ar^1$ - $Ar^5$ have the same meanings as that of the $Ar^1$ described in HTM, n is an integer from 0 to 20, $X^1$~$X^8$ is selected from $CR^1$ or N.

Suitable embodiments which may act as ETM compounds are listed in the following table:

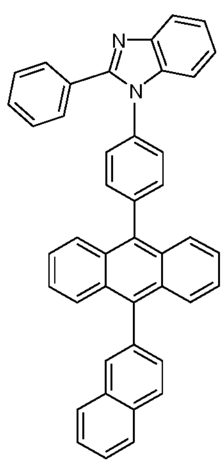
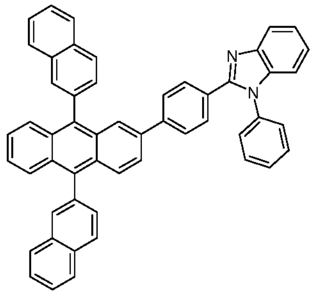
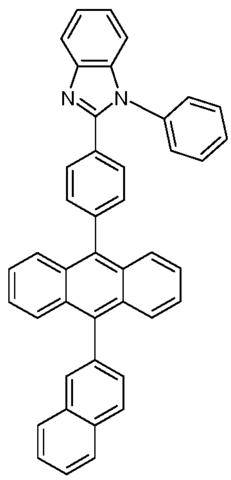

3. Triplet host materials:

Embodiments of the organic compounds which may act as the triplet matrix are selected from compounds comprising cyclic aromatic hydrocarbon groups, such as benzene, biphenyl, triphenyl, benzo, fluorine; from compounds comprising aromatic heterocyclic groups, such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, Triazoles, oxazole, thiazole, oxadiazole, oxatriazole, dioxolane, thiadiazole, pyridine, pyridazine, pyrimidine, pyrazine, triazines, oxazines, oxathiazines, oxadiazines, indole, benzimidazole, Indazole, indoxazine, bisbenzoxazoles, benzisoxazole, benzothiazole, quinoline, isoquinoline, cinnoline, quinazoline, quinoxaline, naphthalene, phthalide, pteridine, xanthene, acridine, phenazine, phenothiazine, phenoxazines, benzofuropyridine, furodipyridine, benzothienopyridine, thienodipyridine, benzoselenophenopyridine and selenophenodipyridine; from groups comprising 2 to 10 cyclic structures, which may be a same or different type of cyclic aromatic hydrocarbon groups or aromatic heterocyclic groups, and be linked with each other directly or through at least one of the following groups: such as oxygen atom, nitrogen atom, sulfur atom, silicon atom, phosphorus atom, boron atom, chain structure unit and aliphatic ring group. Wherein, each Ar may be further substituted, and the substituent may be selected from hydrogen, alkyl, alkoxy, amino, alkene, alkynyl, aralkyl, heteroalkyl, aryl and heteroaryl groups.

The triplet host material may be hole conducting and/or electron conducting.

In a preferred embodiment, the triplet host material may be selected from the compounds comprising at least one of the following groups:

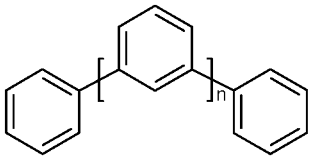
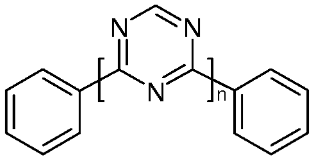
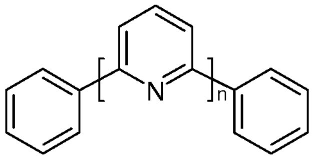

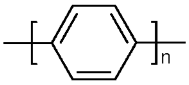
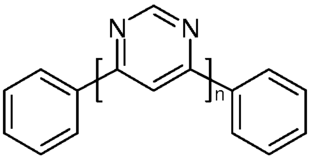
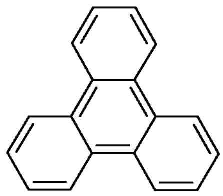
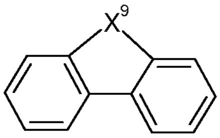
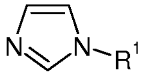

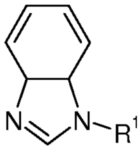
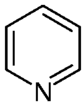
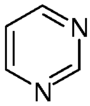
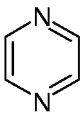
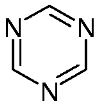
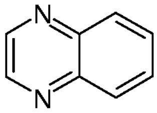
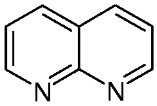
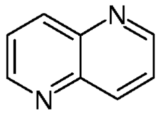

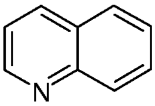
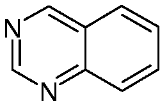
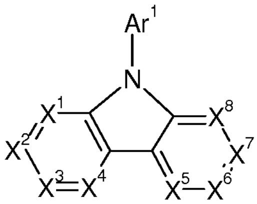
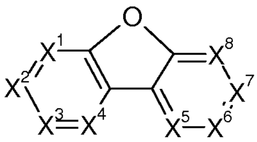
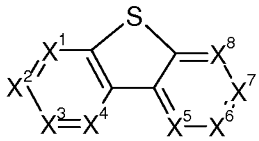

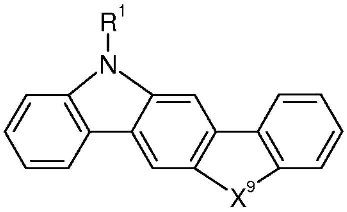
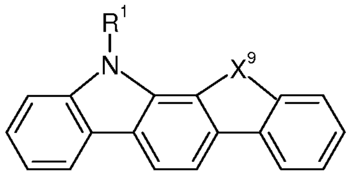
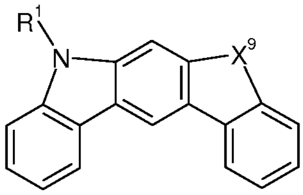

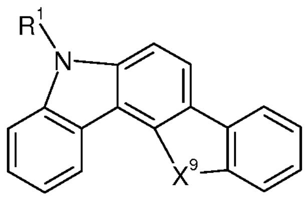
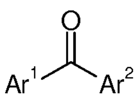
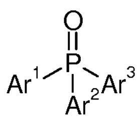
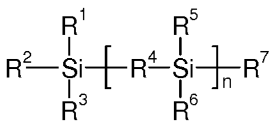

wherein, $R^1$ may be independently selected from the following groups: hydrogen, alkyl, alkoxy, amino, alkene, alkynyl, aralkyl, heteroalkyl, aryl and heteroaryl groups, when they are aryl or heteroaryl groups, they have the same meanings as that of the $Ar^1$ and $Ar^2$ defined in the above said HTM; n is an integer from 0 to 20, $X^1$~$X^8$ is selected from CH or N, $X^9$ is selected from $CR^1R^2$ or $NR^1$.

Detailed embodiments on some triplet host materials are listed in the following table:

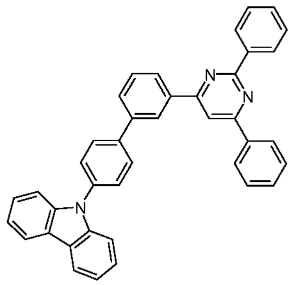

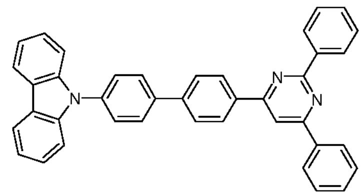

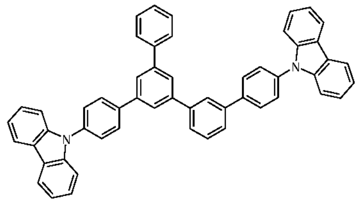

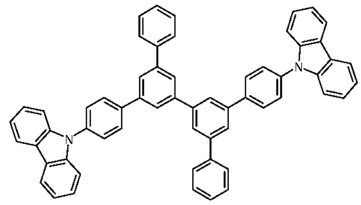

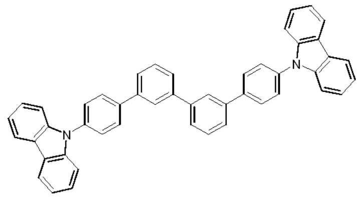

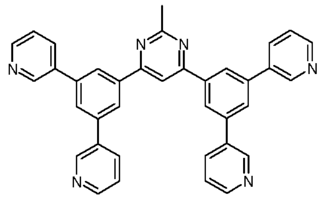

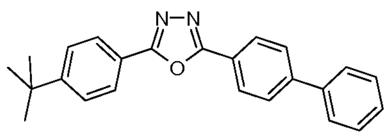

4. Singlet host materials:

Embodiments of the organic compounds which may act as the singlet matrix materials may be selected from compounds comprising cyclic aromatic hydrocarbon groups, such as benzene, biphenyl, triphenyl, benzo, naphthalene, anthracene, phenalene, phenanthrene, fluorine, pyrene, Chrysene, perylene, azulene; from compounds comprising aromatic heterocyclic groups, such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, isoxazole, thiazole, oxadiazole, oxatriazole, dioxolane, thiadiazole, pyridine, pyridazine, pyrimidine, pyrazine, triazine, oxazine, oxathiazine, oxadiazine, indole, benzimidazole, indazole, indoxazine, benzoxazoles, benzisoxazole, benzothiazole, quinoline, isoquinoline, cinnoline, quinazoline, quinoxaline, naphthalene, phthalide, pteridine, xanthene, acridine, phenazine, phenothiazine, phenoxazine, benzofuropyridine, furodipyridine, benzothienopyridine, thienodipyridine, enzoselenophenopyridine and selenophenodipyridine; from groups comprising 2 to 10 cyclic structures, which may be the same or different types of cyclic aromatic hydrocarbon groups or aromatic heterocyclic groups, and they are linked with each other directly or through at least one of the following groups: such as oxygen atom, nitrogen atom, sulfur atom, silicon atom, phosphorus atom, boron atom, chain structure unit and aliphatic ring group.

In a preferred embodiment, the singlet host material may be selected from the compounds comprising at least one of the following groups:

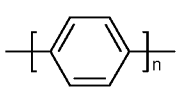

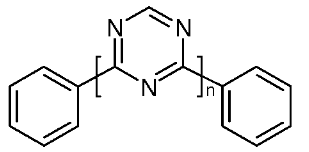

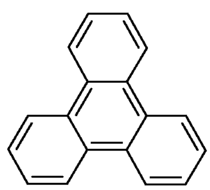

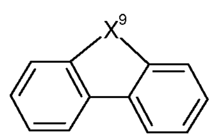

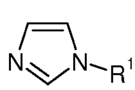

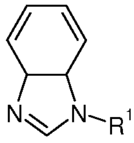
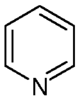
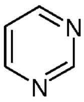
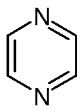
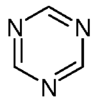
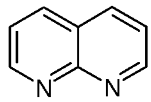
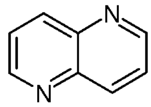

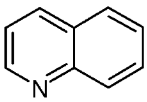
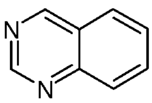
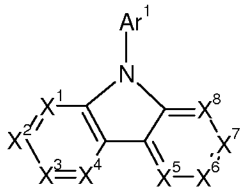
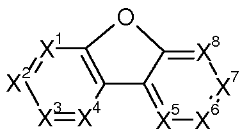
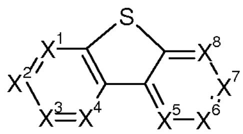

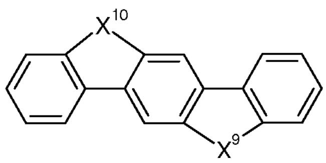
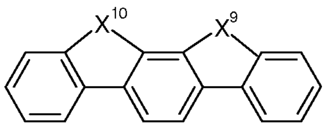
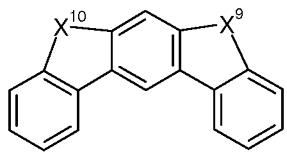

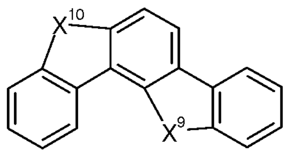
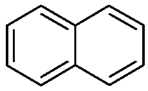
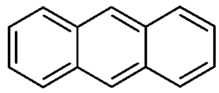
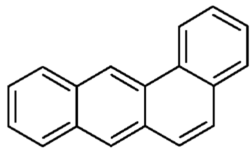

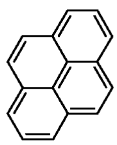
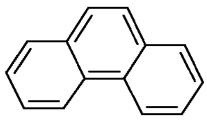
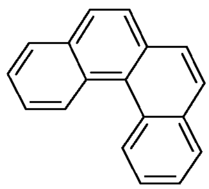

wherein, $R^1$ may be independently selected from the following groups: hydrogen, alkyl, alkoxy, amino, alkene, alkynyl, aralkyl, heteroalkyl, aryl and heteroaryl; $Ar^1$ is an aryl or heteroaryl, it has the same meanings as that of the $Ar^1$ defined in the above said HTM; n is an integer from 0 to 20, $X^1$~$X^8$ is selected from CH or N, $X^9$ and $X^{10}$ is selected from $CR^1R^2$ or $NR^1$.

The following table has listed some embodiments on the anthryl singlet host materials, due to its relatively low T1 energy level, it may be suitable for red or infrared luminescent devices.

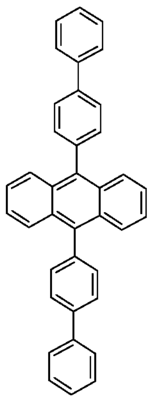
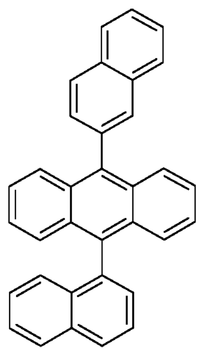
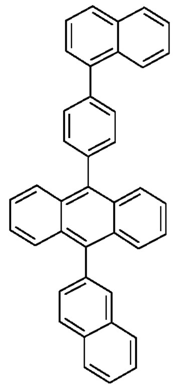

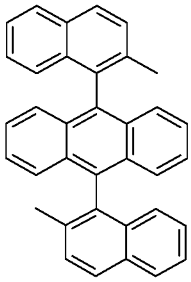

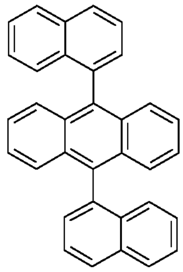

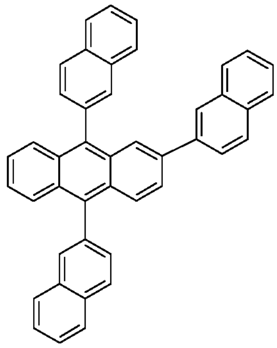

In a preferred embodiment, the said organic mixture, wherein, H1 and H2 may be selected independently from compounds having electrons transport properties and hole transport properties, respectively. The specially preferred combinations are: 1) HTM and electron conducting host materials ; 2) ETM and hole conducting host materials; and 3) HTM and ETM. Some embodiments on the preferred combinations are listed below:

| H1 | H2 |
|---|---|
| 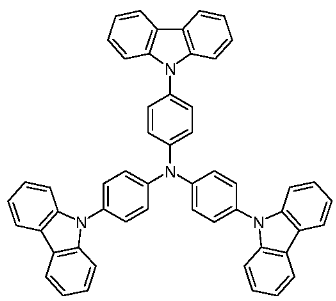 | 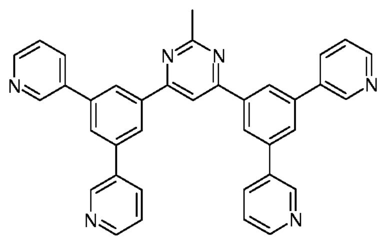 |
| 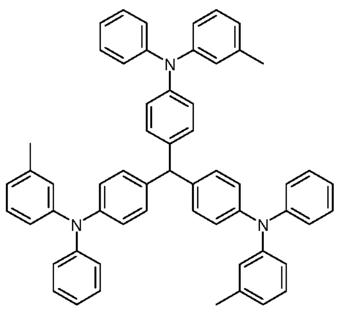 | 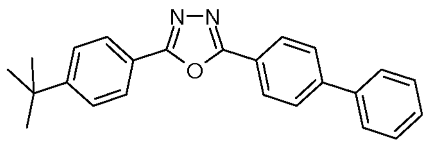 |
| 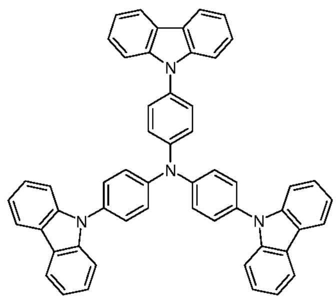 | 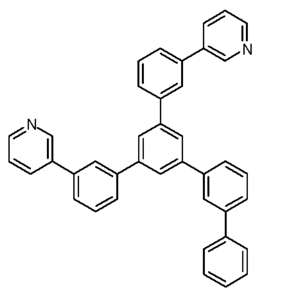 |

(continued)

| H1 | H2 |
| --- | --- |
| 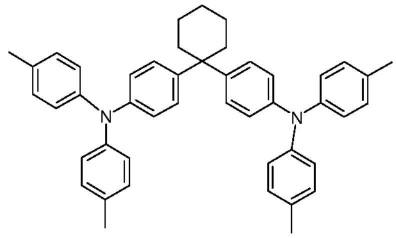 | 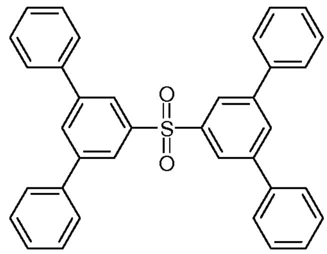 |

In some embodiments, H1 or/and H2 is a polymer material, and at least one recurring unit comprises the above said structure of HTM, ETM or host materials.

In the embodiments of the present invention, E1 is a fluorescent emitter, which is sometimes called a singlet emitter. Usually a fluorescent emitter owns a relatively long conjugated electrons system. So far, there have been a lot of embodiments, such as a styrylamine and the derivative thereof, which has been disclosed in JP2913116B and WO2001021729A1 as well as an indenofluorene and the derivative disclosed in WO2008/006449 and WO2007/140847.

In a preferred embodiment, the fluorescent emitter may be selected from monostyrylamines, distyrylamines, tristyrylamines, tetrastyrylamines, styrylphosphines, styryl ethers and arylamines.

Wherein, a monostyrylamines refers to a compound, which comprises an unsubstituted or substituted styryl group and at least one amine, preferably, an aromatic amine. A distyrylamines refers to a compound, which comprises two unsubstituted or substituted styryl groups and at least one amine, preferably, an aromatic amine. A tristyrylamines refers to a compound, which comprises three unsubstituted or substituted styryl groups and at least one amine, preferably, an aromatic amine. A tetrastyrylamines refers to a compound, which comprises four unsubstituted or substituted styryl groups and at least one amine, preferably, an aromatic amine. A preferred styrene is a diphenylethene, which may be further substituted. The corresponding phosphines and ethers are defined analogously to amines. An arylamine or aromatic amine refers to a compound, comprises three unsubstituted or substituted aromatic or heterocyclic systems directly attached by nitrogen. At least one of these aromatic or heterocyclic systems is preferably selected from fused ring systems, which has at least 14 atoms in the aromatic ring. Wherein, a preferred embodiment thereof, may be aromatic anthracene amines, aromatic anthracene diamines, aromatic pyrene amines, aromatic pyrene diamines, aromatic chrysene amines and aromatic chrysene diamines. An aromatic anthracene amine refers to a compound in which a diarylamino attaches directly to an anthracene, preferably, at a position of 9. An aromatic anthracene diamine refers to a compound, in which two diarylaminos attaches directly to an anthracene, preferably, to the position of 9, 10. Definitions of aromatic pyrene amine, aromatic pyrene diamine, aromatic chrysene amine and aromatic chrysene diamine are similar, wherein, the diarylamino attaches preferably to the position of 1 or 1, 6 of pyrene.

Wherein, embodiments of fluorescent emitter based on vinylamines and aromatic amines, may be found in the following patent documents: WO 2006/000388, WO 2006/058737, WO 2006/000389, WO 2007/065549, WO 2007/115610, US 7250532B2, DE 102005058557A1, CN 1583691 A, JP 08053397A, US 6251531B1, US 2006/210830A, EP 1957606A1 and US 2008/0113101A1, the entire contents of the above listed patent documents are hereby incorporated by reference.

Wherein, embodiments of fluorescent emitter based on distyrylbenzene and the derivative thereof, may be found in US 5121029.

Further preferred fluorescent emitter may be selected from indenofluorene-amines and indenofluorene-diamines as disclosed in WO2006/122630, from benzoindenofluorene-amines and enzoindenofluorene-diamine as disclosed in WO 2008/006449, from dibenzoindenofluorene-amine and dibenzoindenofluorene-diamine as disclosed in WO2007/140847. Other materials that may be applied as fluorescent emitter include polycyclic aromatic hydrocarbon compounds, especially the derivatives of the following compounds: anthracenes such as 9,10-di(2-naphthylanthracene), naphthalene, tetraphenyl, xanthenes, phenanthrene, perylene such as 2,5,8,11-tetra-t-butylperylene, indenoperylene, phenylenes such as (4,4'-(bis(9-ethyl-3-carbazovinylene)-1,1'-biphenyl), periflanthene, decacyclene, coronene, fluorene, spirobifluorene, arylpyrene) (as in US20060222886), arylenevinylene (as in US5121029 and US5130603), tetraphenylcyclopentadiene, rubrene, coumarine, rhodamine, quinacridone, pyrane such as 4 (dicyanoethylene)-6-(4-dimethylaminostyryl-2-methyl)-4H-pyrane (DCM), thiapyran, bis(azinyl)imine-boron compounds (as in US 2007/0092753 A1), bis(azinyl)methane compounds, carbostyryl compounds, oxazone, benzoxazole, benzothiazole, benzimidazole and diketopyrrolopyrrole. Some singlet emitter materials may be found in the following patent documents: US 20070252517 A1, US 4769292, US 6020078, US 2007/0252517 A1 and US 2007/0252517 A1. The entire contents of the above listed

patent documents are incorporated herein by reference.

Some embodiments on fluorescent emitter are listed in the following table:

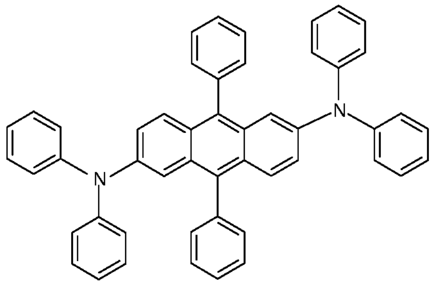

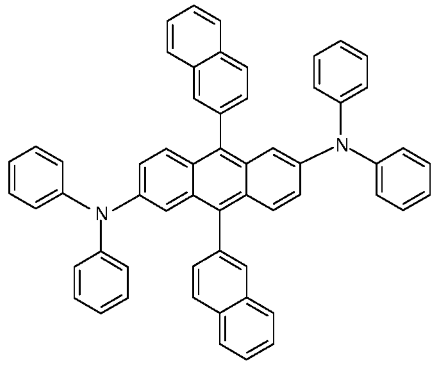

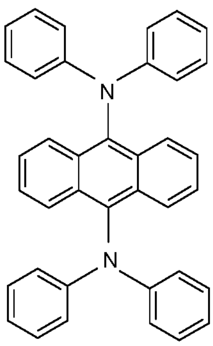

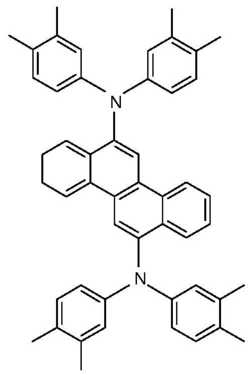

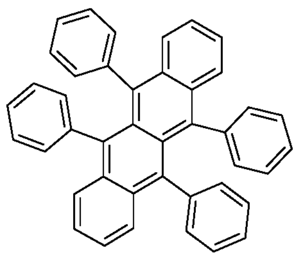

In a preferred embodiment, the said organic mixture, wherein, E1 is a thermally activated delayed fluorescence material (TADF material).

In an embodiment of the present invention, the TADF material is: 1) an organic compound comprising at least one electron donating group D and at least one electron accepting group A, 2) $\Delta$(S1-T1) $\leq$0.25eV, preferably, it is no more than 0.20eV, more preferably, it is no more than 0.15eV, and the best is no more than 0.10eV.

A suitable electron donating group may be selected from a group comprising a core structure as anyone in the following general formulas 1-3:

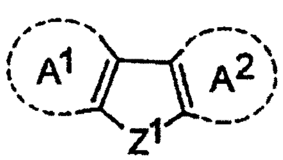

General formula 1

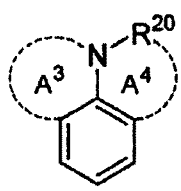

General formula 2

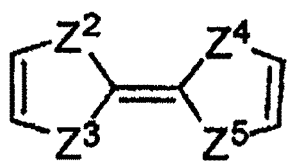

General formula 3

Wherein, $Z^1$=H, O, S or Si, $A^1$ and $A^2$ may independently form an aromatic ring, a heteroaromatic ring, an aliphatic ring or a non-aromatic heterocyclic ring; in the general formula 2, $R^{20}$ represents H, aryl group, or a group of

atoms necessary in forming a ring represented by $A^4$, while $A^3$ and $A^4$ may also form a heteroaromatic ring or a non-heteroaromatic ring; in the general formula 3, each of $Z^2$, $Z^3$, $Z^4$, $Z^5$ represents O or S independently.

In a preferred embodiment, the above said electron-donor group is selected from groups with any core structure listed in the following general formula D1-D10:

| | | | | |
|---|---|---|---|---|
| 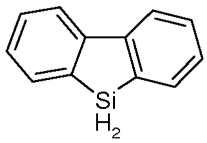 | 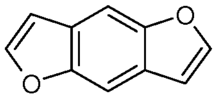 | 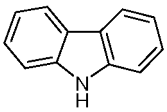 | 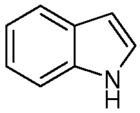 | 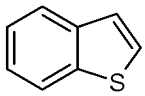 |
| D1 | D2 | D3 | D4 | D5 |
| 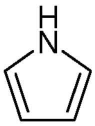 | 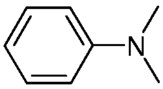 | 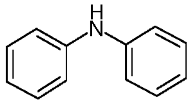 | 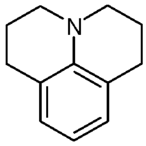 | 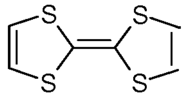 |
| D6 | D7 | D8 | D9 | D10 |

Suitable electron acceptor groups may be selected from F, cyano or groups having a core structure in the following general formulas:

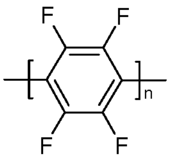 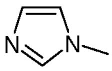 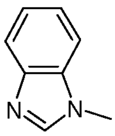 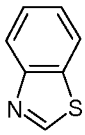 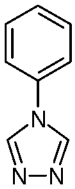 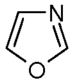 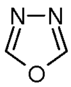

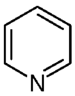 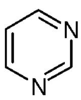 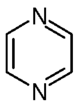 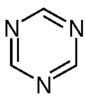 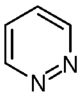 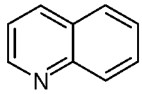 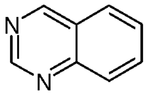 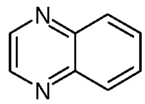

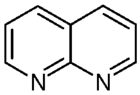 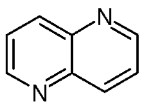 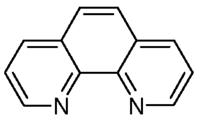 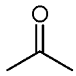 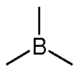 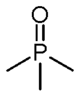

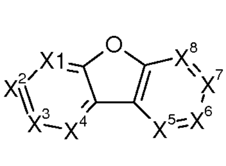 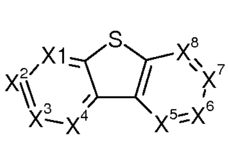 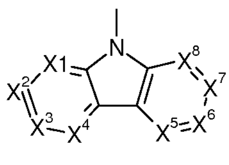

Wherein, n is an integer from 1 to 3; $X^1$ - $X^8$ are selected from $CR^1$ or N, and at least one of them is N, wherein, $R^1$ has a same definition as the $R^1$ defined in ETM.

In a preferred embodiment, the suitable electron acceptor group A is selected from the cyano group.

Some embodiments of the said TADF material are listed below:

| | | |
|---|---|---|
| 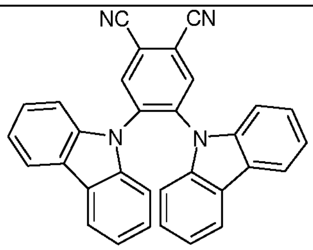 | 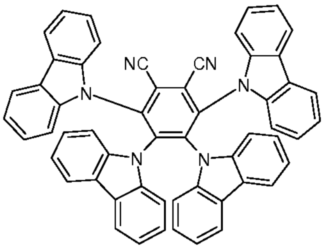 | 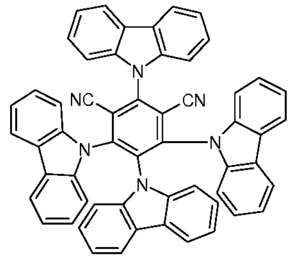 |
| 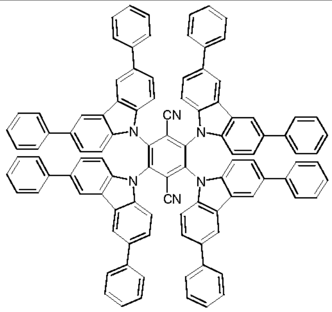 | 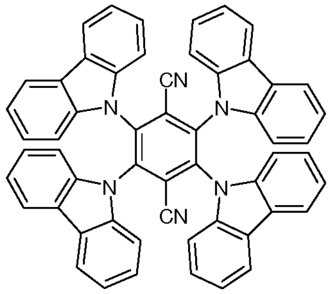 | 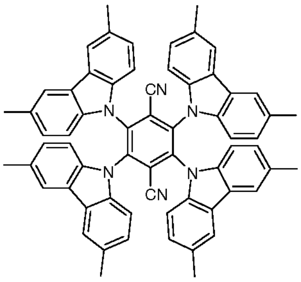 |
| 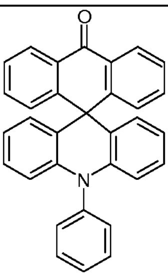 | 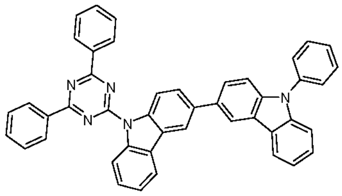 | 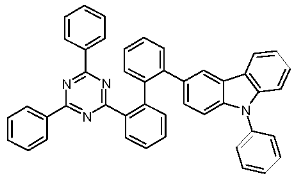 |
| 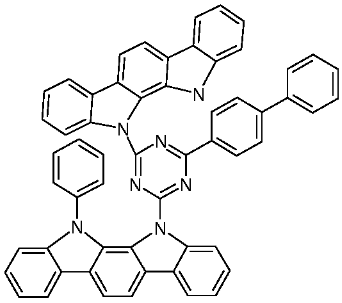 | 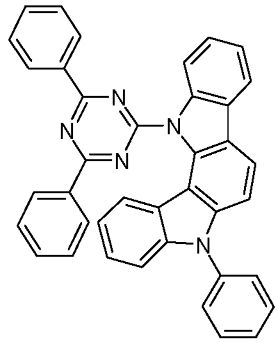 | 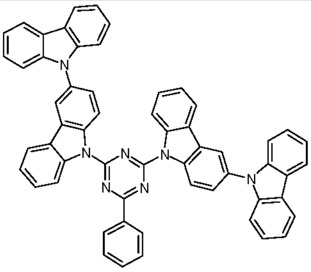 |
| 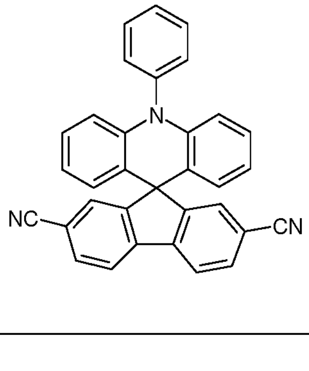 | 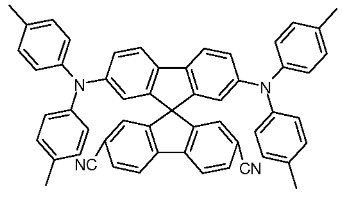 | 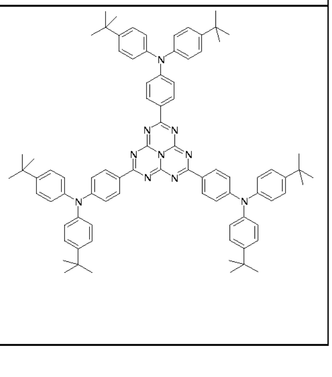 |

| | | |
|---|---|---|
| 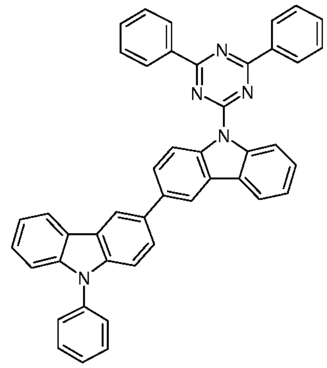 | 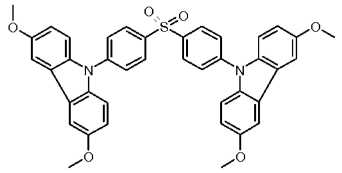 | 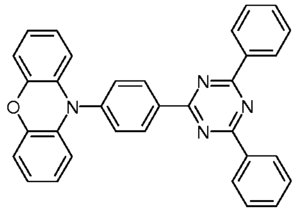 |

In some embodiments, the above said organic mixture further comprises other organic functional materials, including hole injection materials or hole transport materials (HIM/HTM), hole blocking materials (HBM), electron injection materials or electron transport materials (EIM/ETM), electron blocking materials (EBM), organic host materials (Host), singlet emitters (fluorescent emitters), triplet emitters (phosphorescent emitters), and in particular, light-emitting organometallic materials. For example, there are detailed descriptions on all kinds of organic functional materials described in WO2010135519A1, US20090134784A1 and WO 2011110277A1, the entire contents of which are incorporated herein by reference.

The present invention further relates to a formulation, comprising an organic mixture as described above and at least one organic solvent. Examples on the organic solvent, including (but not limited to): methanol, ethanol, 2-methoxyethanol, dichloromethane, trichloromethane, chlorobenzene, o-dichlorobenzene, tetrahydrofuran, anisole, morpholine, Xylene, o-xylene, m-xylene, p-xylene, 1,4-dioxane, acetone, methyl ethyl ketone, 1,2-dichloroethane, 3-phenoxytoluene, 1,1,1-trichloroethane, 1,1,2,2-tetrachloroethane, ethyl acetate, butyl acetate, dimethylformamide, dimethylacetamide, dimethyl sulfoxide, tetrahydronaphthalene, naphthalene alkanes, indenes and/ or the mixtures thereof.

In a preferred embodiment, the formulation according to the present invention is a solution.

In another preferred embodiment, the formulation according to the present invention is a suspension.

The formulation in the embodiments of the present invention may comprise an organic mixture with a weight percentage from 0.01 to 20 wt%, preferably it is from 0.1 to 15 wt%, more preferably it is from 0.2 to 10 wt%, and the most preferably it is 0.25 to 5 wt%.

The present invention further relates to a usage of applying the said formulation as a coating or printing ink to prepare organic electromic devices, and more preferably, to a preparation method of printing or coating.

Wherein, suitable printing or coating techniques include (but not limited to) inkjet printing, letterpress printing, screen printing, dip coating, spin coating, blade coating, roll printing, torsion roll printing, lithography, flexographic printing, rotary printing, spraying, brushing or pad printing, slot-type extrusion coating and more. What are preferred are gravure printing, screen printing and inkjet printing. Gravure printing and inkjet printing will be applied to the embodiments of the present invention. The solution or suspension may additionally comprise one or more components such as surface-active compounds, lubricants, wetting agents, dispersing agents, hydrophobic agents, binders and more, to adjust the viscosities, film-forming properties, improve the adhesions and more. Detailed information on printing techniques, and related requirements on solutions, such as solvents, concentrations, and viscosities, may refer to Handbook of Print Media: Technologies and Production Methods, Helmut Kipphan et al, ISBN 3-540-67326-1.

Based on the above said organic mixture, the present invention further provides an application of the above said organic mixture, that is, the application of the said organic mixture to an organic electronic device, the said organic electronic device may be selected from, but not limited to, an organic light-emitting-diode (OLED), an organic photovoltaic (OPV), an organic light-emitting-electrochemical-cell (OLEEC), an organic field effect transistor (OFET), an organic light-emitting field effect transistor, an organic sensor, an organic plasmon emitting diode, etc., in particular, an OLED. In the embodiments of the present invention, the said organic mixture is preferably applied to an emissive layer of an OLED device.

The present invention further relates to an organic electronic device, which comprises at least one of the above said organic mixtures. Typically, such an organic electronic device comprises at least one cathode, one anode and one functional layer between the cathode and the anode, wherein, the said functional layer comprises at least one of the above said organic mixtures.

In the above said luminescent devices, particularly in the OLED, there are a substrate, an anode, at least one emissive layer and one cathode.

The substrate may be opaque or transparent. A transparent substrate may be used to create a transparent

luminescence component. For example, it may be referred to, Bulovic, et. al., Nature 1996, 380, p29, and Gu, et. al., Appl. Phys. Lett. 1996, 68,p2606. The substrate may be rigid or elastic, may be a plastic, a metal, a semiconductor wafer or a glass. Preferably, the substrate has a smooth surface. A substrate without any surface defects is particularly desirable. In a preferred embodiment, the substrate is flexible, which may be selected from a polymeric film or a plastic, whose glass transition temperature Tg is above 150°C, preferably above 200°C, more preferably above 250°C, the most preferably above 300°C. Examples of suitable flexible substrate includes poly (ethylene terephthalate) (PET) and polyethylene glycol (2,6-naphthalene) (PEN)

The anode may comprise a conductive metal or metal oxide, or a conductive polymer. The anode can inject holes into a hole-injection-layer (HIL) or a hole-transport-layer (HTL) or an emissive layer easily. In an embodiment, an absolute value of the difference between the work function of the anode and the HOMO energy level or the valance band level of the emitter in the emissive layer or the p-type semiconductor material acting as the HIL or the HTL or the electron-blocking layer, is smaller than 0.5eV, preferably smaller than 0.3eV, the most preferably smaller than 0.2eV. Examples on anode materials include but not limited to: Al, Cu, Au, Ag, Mg, Fe, Co, Ni, Mn, Pd, Pt, ITO, Aluminum-doped Zinc Oxide (AZO) and else. While other suitable anode materials are already known, and may be selected and used by ordinary technical personnel in this field easily. An anode material may be applied by any suitable technical deposition method, such as a suitable physical vapor deposition method, which includes radio-frequency magnetron sputtering, vacuum thermal evaporation, electron beam (e-beam) and else. In some embodiments, the anode is patterned. A patterned ITO conductive substrate is commercially available, and may be used to prepare devices according to the present invention.

The cathode may include a conductive metal or a metal oxide. The cathode can inject electrons to the EIL or ETL or directly to the emissive layer easily. In an embodiment, an absolute value of the difference between the work function of the cathode and the LUMO energy level or the valance band level of the emitter in the emissive layer or the n-type semiconductor material acting as the electron-injection-layer (EIL) or the electron-transport-layer (ETL) or the hole-blocking-layer (HBL), is smaller than 0.5eV, preferably smaller than 0.3eV, the most preferably smaller than 0.2eV. In principle, all of the materials that may be applied as cathodes of the OLED may also serve as the cathode materials of the devices in the present invention. Examples of the cathode materials include but not limited to: Al, Au, Ag, Ca, Ba, Mg, LiF/Al, MgAg alloy, BaF2/Al, Cu, Fe, Co, Ni, Mn, Pd, Pt, ITO and more. A cathode material may be applied by any suitable technical deposition method, such as a suitable physical vapor deposition method, which includes radio-frequency magnetron sputtering, vacuum thermal evaporation, electron beam (e-beam) and else.

An OLED may also include other functional layers, such as a hole-injection layer (HIL), a hole-transport layer (HTL), an electron-blocking layer (EBL), an electron-injection layer (EIL), an electron-transport layer (ETL), a hole-blocking layer (HBL). Materials that suit for these functional layers have been described in details in WO2010135519A1, US20090134784A1 and WO2011110277A1, the entire contents of which are incorporated herein by reference.

In a preferred embodiment, in the light emitting devices according to the present invention, the emissive layer thereof is prepared by printing the formulation as described in the present invention.

The light emitting device according to the present invention has an emitting wavelength between 300 and 1000 nm, preferably, between 350 and 900 nm, more preferably, between 400 and 800 nm.

The present invention further relates to an application of the organic electronic devices in accordance with the present invention in various electronic devices including, but not limited to, a display device, an illumination device, a light source, a sensor and else.

The present invention further relates to a plurality of electronic devices comprising organic electronic devices in accordance with the present invention, including but not limited to, a display device, an illumination device, a light source, a sensor and else.

Further detailed descriptions of the present invention are stated here, referencing to some preferred embodiments, but the present invention is not limited to the embodiments described below. It should be understood that, the application of the present invention is not limited to the above examples listed. Ordinary technical personnel in this field can improve or change the applications according to the above descriptions, all of these improvements and transforms should belong to the scope of protection in the appended claims of the present invention.

Examples:

In the present embodiment, the first host material H1, the second host material H2 can be TCTA and B3PYMPM, respectively. The structure formula of TCTA is as follows:

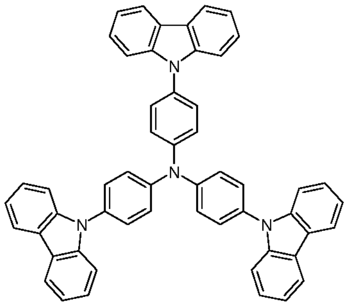

The structure formula of B3PYMPM is as follows:

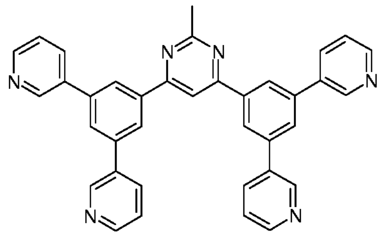

The two host materials can form an exciplex, and can form a type-II heterojunction structure.

The said organic fluorescent emitting material E1 can be Emitter 1, which is a commonly used red fluorescent emitter, whose structure formula is as follows:

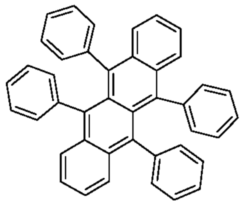

While in the present invention, thermal activated delayed fluorescence materials (TADF material) is more preferred, such as an Emitter 2, (referencing to Chem. Commun. Vol48, p11392), whose structural formula is as follows:

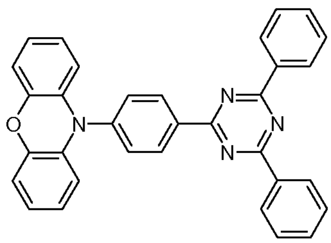

The synthesis methods of TCTA, B3PYMPM, Emitter1 and Emitter2 all belong to the prior art, please refer to the reference documents listed in the prior art for details, which will not be stated here again.

The energy levels of an organic material can be calculated by quantum calculations, for example, using TD-DFT (Time dependent- Density Functional Theory) through Gaussian03W(Gaussian Inc.), the detailed simulation method may refer to WO2011141110. First, use a semi-empirical method "Ground State / Semi-empirical/ Default Spin / AM1" (Charge 0 / Spin Singlet) to optimize a molecular geometry structure, then, the energy structure of the organic molecule is calculated by using the TD-DFT method for "TD-SCF/DFT/ Default Spin/B3PW91" and the base group "6-31 G(d)" (Charge 0/Spin Singlet). The HOMO and LUMO energy levels are calculated according to the following formulas, S1 and T1 are used directly:

$$HOMO(eV) = ((HOMO(G)\times 27.212)-0.9899)/1.1206$$

$$LUMO(V) = ((LUMO(G)\times 27.212)-2.0041)/1.385$$

Wherein, HOMO(G) and LUMO(G) are directly calculated by Gaussian 03W, with a unit of Hartree. The results are shown in the table I:

Table I:

| Material | HOMO [eV] | LUMO [eV] | T1 [eV] | S1 [eV] |
|---|---|---|---|---|
| H1 (B3PYMPM) | -6,72 | -2,85 | 2,97 | 3,46 |
| H2 (TATC) | -5,33 | -2,20 | 2,72 | 3,28 |
| Emitter1 | -5,10 | -3,03 | 0,93 | 2,22 |
| Emitter2 | -5,32 | -2,91 | 2,39 | 2,48 |

Wherein, min(Δ($LUMO_{(H1)}$ -$HOMO_{(H2)}$), Δ($LUMO_{(H2)}$ -$HOMO_{(H1)}$))=2.48eV, which is less than the lowest triplet excited state energy level (T1) of H1 and H2. Also, S1 of both Emitter 1 and Emitter 2 are smaller than or equal to min(Δ($LUMO_{(H1)}$ -$HOMO_{(H2)}$), Δ($LUMO_{(H2)}$ -$HOMO_{(H1)}$)).

The preparation process of an OLED device using the above said organic mixture is described as follows, referencing to a plurality of embodiments. A structure of the said OLED device is: ITO/HIL/HTL/EML/ETL/cathode, and the preparation steps are as follows:

a. Clean an ITO (Indium tin oxide) conductive glass substrate: cleaning the substrate using a variety of solvents (such as one or more of chloroform, acetone or insopropanol), followed by a UV and ozone treatment;

b. HIL: a 60nm PEDOT (Polyethylene dioxythiophene, Clevios™ AI4083) is applied as the HIL, which is coated by spin-coating in a clean room, and is then treated on a hot plate at 180°C for 10 minutes;

c. HTL: coated by spin-coating a 20nm TFB in a nitrogen glove box, the solution to use is prepared by adding TFB into a toluene solvent, whose concentration is 5mg/ml, followed by treating on a hot plate at 180°C for 60 minutes;

Wherein, TFB is a hole transport material for HTL, whose structure formula is as follows:

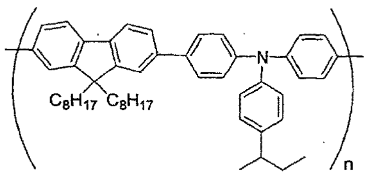

"TFB"

d. EML (an organic emissive layer, 40nm): thermally deposited in a high vacuum ($1\times 10^{-6}$ mbar) according to the composition of a table II;

| OLED device | EML composite (in wt%) |
|---|---|
| OLED1 | H2(48%):H1(47%):Emitter1(5%) |
| OLED2 | H2(48%):H1(47%):Emitter2(5%) |
| Ref1 | H2(95%):Emitter1(5%) |
| Ref2 | H2(95%):Emitter2(5%) |

e. ETL (electron transport layer, 40nm): made by the H1 of 40nm thermally deposited in a high vacuum ($1\times 10^{-6}$ mbar);

f. Cathode: made by LiF/Al(1nm/150nm) thermally deposited in a high vacuum ($1\times 10^{-6}$ mbar);

g. Encapsulation: the device is finally encapsulated in a nitrogen glove box, using a UV-curable resin.

The characteristics of current-voltage (J-V) of each OLED device are measured by an evaluation system, while recording important parameters including efficiency, lifetime and external quantum efficiency. After testing, both the luminous efficiency and lifetime of the OLED1 is over 3 times of that of Ref1, while the luminous efficiency of OLED2 is 4 times of that of Ref2, and the lifetime is over 6 times, especially, the maximum external quantum efficiency is improved significantly.

## Claims

1. An organic mixture, wherein, it comprises a first host material H1, and a second host material H2 applied to form an exciplex together with the first host material H1, and an organic fluorescence emissive material E1, the H1 and H2 form a type II heterojunction structure, and the emitting wavelength of E1 is larger than or equal to that of the exciplex formed by H1 and H2.

2. The organic mixture according to claim 1, wherein, min($\Delta$($LUMO_{H1}$-$HOMO_{H2}$), $\Delta$($LUMO_{H2}$-$HOMO_{H1}$)) is smaller than or equal to the energy of the triplet excited state of H1 and H2.

3. The organic mixture according to claim 1 or 2, wherein, the absorption spectrum of E1 is at least partially overlapping with the luminescence spectrum of the exciplex formed by H1 and H2.

4. The organic mixture according to claim 3, wherein E1 is no more than 15wt%.

5. The organic mixture according to claim 1 or 2, wherein, the fluorescence emissive material E1 is selected from compounds based on amines, such as monostyrylamines, distyrylamines, tristyrylamines, tetrastyrylamines, styrylphosphines, styryl ethers or arylamines, or a compound based on polycyclic aromatic hydrocarbons.

6. The organic mixture according to claim 1 or 2, wherein, E1 is a thermal activated delayed fluorescence material, wherein, E1 comprises at least one electron donating group D and at least one electron accepting group A, $\Delta$(S1-T1) $\leq$0.25eV.

7. The organic mixture according to claim 6, wherein, the structure formula of E1 is

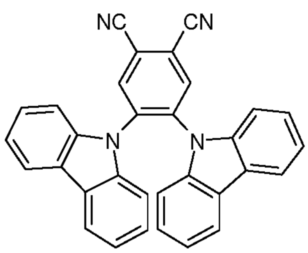

or

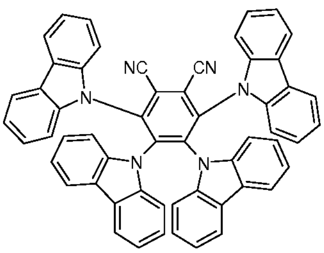

or

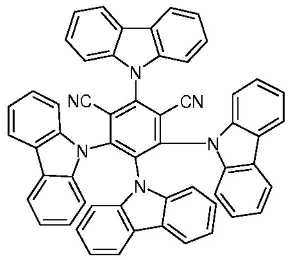

or

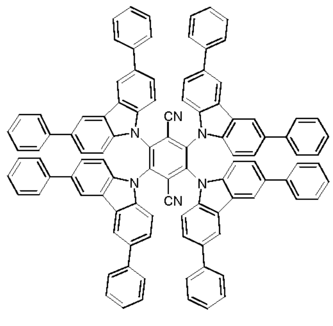

or

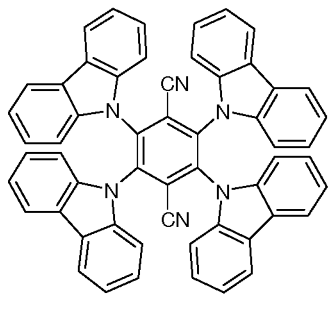

or

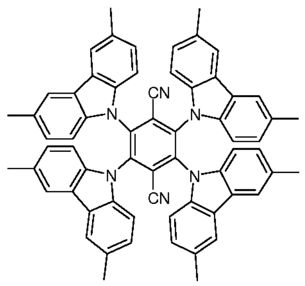 or 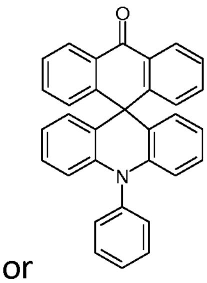 or 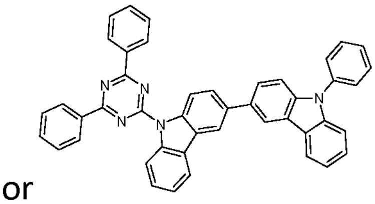

or

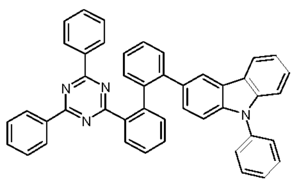 or 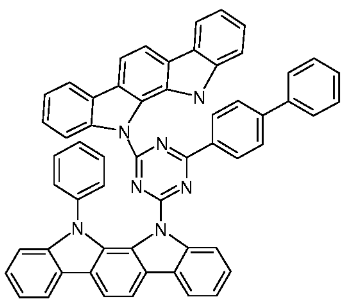 or 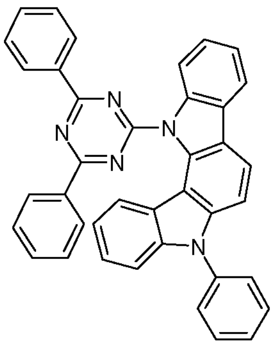

or

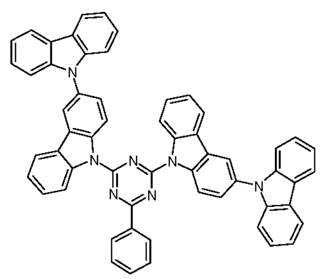 or 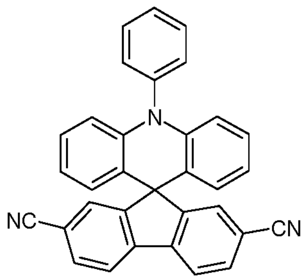

or

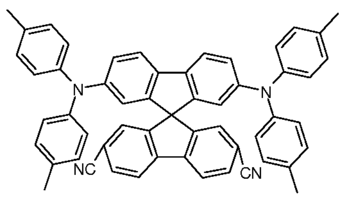 or 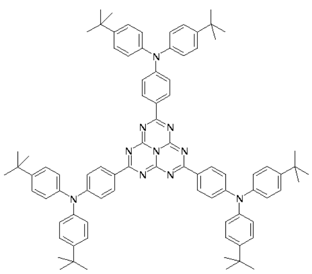

or

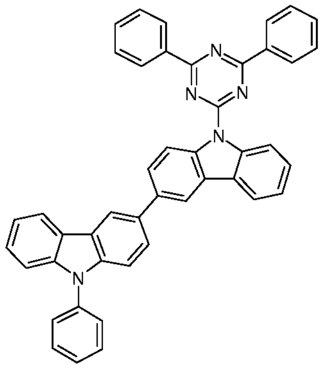

or

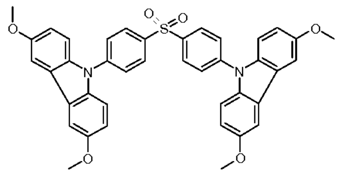

or

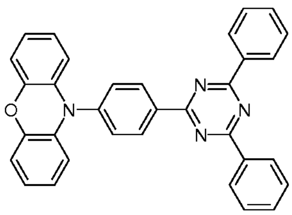

.

**8.** The organic mixture according to claim 1 or 2, wherein, H1 and H2 are independently selected from a hole transport material, an electron transport material, or a host material, wherein, one owns a hole transport feature, the other owns an electron transport feature.

**9.** The organic mixture according to claim 8, wherein, the structural formula of the first host material H1 is

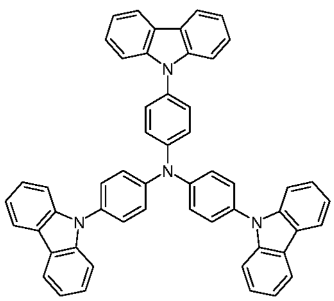

or

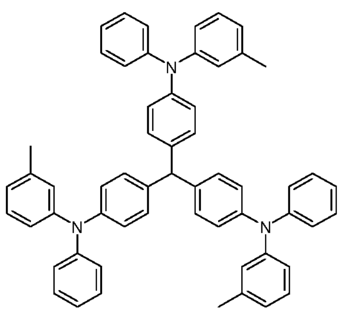

or

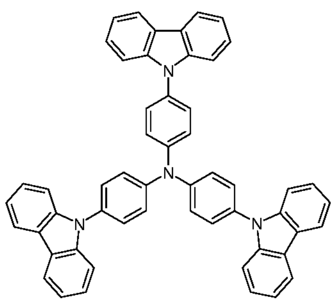

or

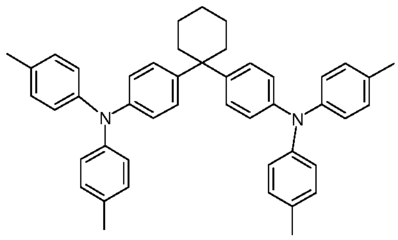

;

the structural formula of the second host material H2 is

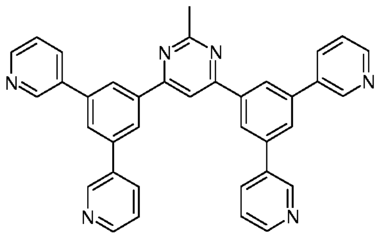

or

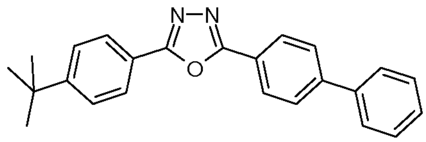

or

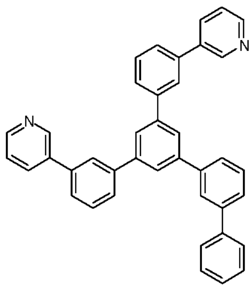

or

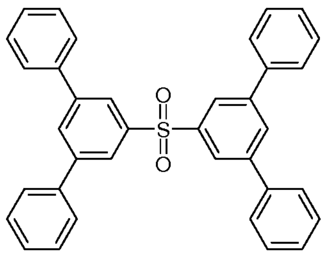

.

**10.** A formulation, wherein, it comprises at least one organic solvent and the organic mixture according to anyone of the claims 1 to 9.

**11.** An application in the organic electronic devices, of the organic mixture according to anyone of the claims 1 to 9.

**12.** An organic electronic device, wherein, it comprises at least an organic mixture according to anyone of the claims 1 to 9.

**13.** An organic electronic device according to claim 12, wherein, the organic electronic device is an organic light-emitting diode (OLED), an organic photovoltaic (OPV), an organic light-emitting-electrochemical-cell (OLEEC), an organic field effect transistor (OFET), an organic light-emitting field effect transistor, an organic sensor, an organic Plasmon emitting diode.

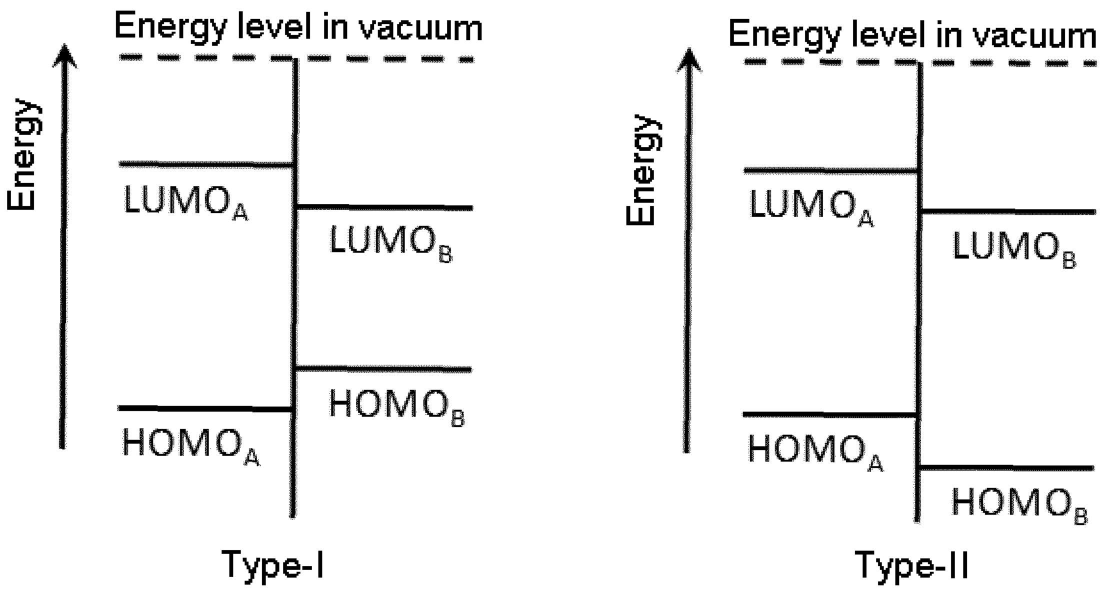

Energy level in vacuum
Energy
LUMO_A
LUMO_B
HOMO_B
HOMO_A
Type-I
Energy level in vacuum
Energy
LUMO_A
LUMO_B
HOMO_A
HOMO_B
Type-II


Fig. 1

# INTERNATIONAL SEARCH REPORT

International application No.
**PCT/CN2015/074966**

**A. CLASSIFICATION OF SUBJECT MATTER**

H01L 51/54 (2006.01) i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNPAT, WPI, EPODOC, CNKI: GUANGZHOU HUARUI PHOTOELECTRIC MATERIAL CO., LTD.; YAN, Xiaolin; thermal dissipation, thermal activation, delay fluorescent, TADF, organic, electrolumin+, OLED, OELD, first host, second host, first matrix, second matrix, dopant, delayed fluorescen+

**C. DOCUMENTS CONSIDERED TO BE RELEVANT**

| Category* | Citation of document, with indication, where appropriate, of the relevant passages | Relevant to claim No. |
|---|---|---|
| X | KIM, B.S. et al. "Engineering of Mixed Host for High External Quantum Efficiency above 25% in Green Thermally Activated Delayed Fluorescence Device", ADV. FUNCT. MATER., vol. 24, 24 March 2014 (24.03.2014), pages 3970-3977 | 1-13 |
| A | WO 2013154064 A1 (KYUSHU UNIVERSITY NATIONAL UNIVERSITYCORPORATION), 17 October 2013 (17.10.2013), description, page 56, line 2, page 59, line 4 and pages 65-74, synthesis examples 1, 2, 4, 6, 9 and 10 | 1-13 |
| A | TW 201350558 A (KYUSHU UNIVERSITY, NATIONAL UNIVERSITY CORPORATION), 16 December 2013 (16.12.2013), description, page 18, line 1 and page 59, embodiment 2 | 1-13 |
| A | US 2014131665 A1 (UNIVERSAL DISPLAY CORPORATION), 15 May 2014 (2014-05 -15), description, paragraph 57, compound 1 | 1-13 |
| A | TW 201343651 A (KYUSHU UNIVERSITY, NATIONAL UNIVERSITY CORPORATION), 01 November 2013 (01.11.2013), description, page 12, line 1 | 1-13 |

☒ Further documents are listed in the continuation of Box C. ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 02 June 2015 (02.06.2015) | **19 June 2015 (19.06.2015)** |

| Name and mailing address of the ISA/CN: | Authorized officer |
|---|---|
| State Intellectual Property Office of the P. R. China<br>No. 6, Xitucheng Road, Jimenqiao<br>Haidian District, Beijing 100088, China<br>Facsimile No.: (86-10) 62019451 | **ZHANG, Hengjun**<br>Telephone No.: (86-10) **82246670** |

Form PCT/ISA/210 (second sheet) (July 2009)

## INTERNATIONAL SEARCH REPORT

International application No. PCT/CN2015/074966

**C (Continuation). DOCUMENTS CONSIDERED TO BE RELEVANT**

| Category* | Citation of document, with indication, where appropriate, of the relevant passages | Relevant to claim No. |
|---|---|---|
| A | CN 103688384 A (KYUSHU UNIVERSITY, NATIONAL UNIVERSITY CORPORATION), 26 March 2014 (26.03.2014), description, page 9, paragraph 99 and page 18, embodiment 1 | 1-13 |
| A | CN 102648268 A (NIPPON STEEL CHEMICAL CO., LTD. et al.), 22 August 2012 (22.08.2012), description, page 11, compound 11 and page 12, compound 20 | 1-13 |
| A | WO 2013081088 A1 (UNIV KYUSHU UNIVERSITY NATIONAL UNIVERSITYCORPORATION), 06 June 2013 (06.06.2013), description, page 20, paragraph 41, compound 1 and page 63, embodiment 1 | 1-13 |
| A | TW 201343874 A (KYUSHU UNIVERSITY, NATIONAL UNIVERSITY CORPORATION), 01 November 2013 (01.11.2013), description, page 71, embodiment 1 and page 76, line 1 | 1-13 |
| A | CN 103650195 A (KYUSHU UNIVERSITY, NATIONAL UNIVERSITY CORPORATION), 19 March 2014 (19.03.2014), description, pages 36-39, compounds 1 and 283 and embodiments 1 and 141 | 1-13 |
| A | SASABE, H. et al. “A m-terphenyl-modifed Sulfone Derivative as a Host Material for High-efficiency Blue and Green Phosphorescent OLEDs”, CHEM, MATER., vol. 24, 03 April 2012 (03.04.2012), pages 1404-1406 | 1-13 |
| PX | CN 103985822 A (GUANGZHOU HUARUI PHOTOELECTRIC MATERIAL CO., LTD.), 13 August 2014 (13.08.2014), claims 1-13 | 1-13 |

Form PCT/ISA/210 (continuation of second sheet) (July 2009)

**INTERNATIONAL SEARCH REPORT**
Information on patent family members

International application No.
**PCT/CN2015/074966**

| Patent Documents referred in the Report | Publication Date | Patent Family | Publication Date |
|---|---|---|---|
| WO 2013154064 A1 | 17 October 2013 | KR 20150005583 A | 14 January 2015 |
| | | EP 2851408 A1 | 25 March 2015 |
| | | US 2015105564 A1 | 16 April 2015 |
| | | TW 201402776 A | 16 January 2014 |
| | | JP 2014135466 A | 24 July 2014 |
| | | CN 104204132 A | 10 December 2014 |
| TW 201350558 A | 16 December 2013 | US 2015041784 A1 | 12 February 2015 |
| | | JP 2013256490 A | 26 December 2013 |
| | | KR 20150009512 A | 26 January 2015 |
| | | WO 2013172255 A1 | 21 November 2013 |
| | | CN 104136430 A | 05 November 2014 |
| | | JP 5594750 B2 | 24 September 2014 |
| | | EP 2808323 A1 | 03 December 2014 |
| US 2014131665 A1 | 15 May 2014 | JP 2014096586 A | 22 May 2014 |
| | | TW 201425310 A | 01 July 2014 |
| TW 201343651 A | 1 November 2013 | US 2015048338 A1 | 19 February 2015 |
| | | CN 104159994 A | 19 November 2014 |
| | | WO 2013133359 A1 | 12 September 2013 |
| | | EP 2824159 A1 | 14 January 2015 |
| | | KR 20140143393 A | 16 December 2014 |
| CN 103688384 A | 26 March 2014 | WO 2013011955 A1 | 24 January 2013 |
| | | EP 2733761 A1 | 21 May 2014 |
| | | JP WO2013011955 A1 | 23 February 2015 |
| | | KR 20140058550 A | 14 May 2014 |
| | | TW 201309696 A | 01 March 2013 |
| | | US 2014138669 A1 | 22 May 2014 |
| CN 102648268 A | 22 August 2012 | US 2012241732 A1 | 27 September 2012 |
| | | WO 2011070963 A1 | 16 June 2011 |
| | | KR 20120112517 A | 11 October 2012 |
| | | TW 201136931 A | 01 November 2011 |
| | | KR 101317923 B1 | 16 October 2013 |
| | | US 8993129 B2 | 31 March 2015 |
| | | EP 2511360 A1 | 17 October 2012 |
| | | CN 102648268 B | 13 August 2014 |
| | | JP 5124785 B2 | 23 January 2013 |
| | | EP 2511360 A4 | 21 May 2014 |
| WO 2013081088 A1 | 6 June 2013 | JP 5679496 B2 | 04 March 2015 |
| | | EP 2787549 A1 | 08 October 2014 |
| | | KR 20140106631 A | 03 September 2014 |
| | | CN 103959502 A | 30 July 2014 |
| | | US 2014336379 A1 | 13 November 2014 |
| TW 201343874 A | 1 November 2013 | KR 20150016242 A | 11 February 2015 |
| | | WO 2013161437 A1 | 31 October 2013 |
| | | CN 104271701 A | 07 January 2015 |
| | | EP 2862913 A1 | 22 April 2015 |
| CN 103650195 A | 19 March 2014 | WO 2013011954 A1 | 24 January 2013 |
| | | EP 2733762 A1 | 21 May 2014 |
| | | JP 5565742 B2 | 06 August 2014 |
| | | TW 201309778 A | 01 March 2013 |

Form PCT/ISA/210 (patent family annex) (July 2009)

## INTERNATIONAL SEARCH REPORT
Information on patent family members

International application No.
**PCT/CN2015/074966**

| Patent Documents referred in the Report | Publication Date | Patent Family | Publication Date |
|---|---|---|---|
| | | JP WO2013011954 A1 | 23 February 2015 |
| | | US 2014138670 A1 | 22 May 2014 |
| | | KR 20140061365 A | 21 May 2014 |
| | | EP 2733762 A4 | 15 April 2015 |
| CN 103985822 A | 13 August 2014 | None | |

Form PCT/ISA/210 (patent family annex) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011141110 A
- WO 2010135519 A1
- US 20090134784 A1
- WO 2011110277 A1
- US 3567450 A
- US 4720432 A
- US 5061569 A
- US 3615404 A
- JP 2913116 B
- WO 2001021729 A1
- WO 2008006449 A
- WO 2007140847 A
- WO 2006000388 A
- WO 2006058737 A
- WO 2006000389 A
- WO 2007065549 A
- WO 2007115610 A
- US 7250532 B2
- DE 102005058557 A1
- CN 1583691 A
- JP 08053397 A
- US 6251531 B1
- US 2006210830 A
- EP 1957606 A1
- US 20080113101 A1
- US 5121029 A
- WO 2006122630 A
- US 20060222886 A
- US 5130603 A
- US 20070092753 A1
- US 20070252517 A1
- US 4769292 A
- US 6020078 A


### Non-patent literature cited in the description


- **KIM.** *Adv. Func. Mater.,* 2013
- **ADACHI et al.** *Nature Photonics,* 2012, vol. 6, 253
- **ADACHI et al.** *Nature,* 2012, vol. 492, 234
- Dendrimers and Dendrons. Wiley-VCH Verlag GmbH & Co. KGaA, 2002
- **HELMUT KIPPHAN et al.** Handbook of Print Media: Technologies and Production Methods
- **BULOVIC.** *Nature,* 1996, vol. 380, 29
- **GU.** *Appl. Phys. Lett.,* 1996, vol. 68, 2606
- *Chem. Commun.,* vol. 48, 11392